# EUROPEAN PATENT APPLICATION

(11) **EP 4 779 402 A1**
(43) Date of publication of application: **22.07.2026**
(21) Application number: 25152555.6
(22) Date of filing: 17.01.2025
(51) Int. Cl.: G03F 7/00

(54) **ELECTROSTATIC DISCHARGE DETECTION IN EXPOSURE APPARATUS**

(71) Applicant: ASML Netherlands B.V., 5500 AH Veldhoven (NL)
(72) Inventor: VAN WANROOIJ, Jeroen Earl, 5500AH Veldhoven (NL)
(74) Representative: ASML Netherlands B.V.

(57) **Abstract**

A detection system for use in an exposure apparatus comprises at least two radio frequency receivers (ANT) configured to receive signals in the exposure apparatus. The detection system further comprises a signal processing unit (SPU) comprising a software defined radio (SDR) configured to process the received signals. The signal processing unit (SPU) is further configured to determine an occurrence of a discharge of charged particles in the exposure apparatus from the processed signals.

## Description

### FIELD

The present invention relates to a detection system for use in an exposure apparatus, an exposure apparatus comprising said detection system and a method of determining a cause of electrostatic discharge in an exposure apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In a lithographic apparatus, electrostatic charge may be built up. Further, the lithographic may be configured to generate irradiation pulses using a plasma. Consequentially, in the lithographic apparatus, an electrostatic discharge or a plasma discharge may take place. A location, a discharge energy and a time of occurrence of the discharge may be highly random or highly unpredictable. Moreover, the higher the radiation source intensity and the higher throughput and scanning velocities of the lithographic apparatus, the higher a risk of occurrence of such discharges may be and the higher a likelihood may be that the discharge may have an impact on the operation of the lithographic apparatus. The electrostatic discharges and/or plasma discharges may result in disturbances of the lithographic apparatus, which may result in damage, in a reduction of a mean time between failures and in an increase of a mean time to repair.

### SUMMARY

The invention aims to enhance a reliability of operation of an exposure apparatus.

According to an aspect of the invention, there is provided a detection system for use in an exposure apparatus, comprising:
at least two radio frequency receivers configured to receive signals in the exposure apparatus;
a signal processing unit comprising a software defined radio configured to process the received signals, wherein the signal processing unit is further configured to determine an occurrence of a discharge of charged particles in the exposure apparatus from the processed signals.

According to an aspect of the invention, there is provided an exposure apparatus comprising said detection system.

According to an aspect of the invention, there is provided a method of determining a cause of electrostatic discharge in an exposure apparatus, the method comprising:
receiving by at least two radio frequency receivers signals in the exposure apparatus;
processing the signals by a software defined radio, and
determining an occurrence of a discharge of charged particles in the exposure apparatus from the processed signals.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a highly schematic view of a substrate stage compartment of a lithographic apparatus;
- Figure 3A - 3D depict embodiments of an antenna;
- Figure 4 depicts a block schematic of a detection system configured to be used in a lithographic apparatus.

### DETAILED DESCRIPTION

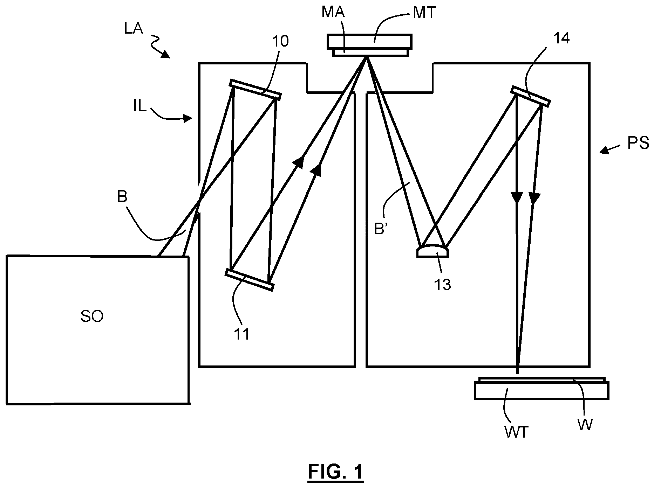

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

As described above, in the lithographic system, an electrostatic discharge or a plasma discharge may take place. For example, electrostatic charge may be built up, e.g. as a result of movements of movable parts of the lithographic system. Further, the lithographic system may be configured to generate irradiation pulses using a plasma. Plasma discharges of the plasma may occur. Discharges may for example be caused by friction between movable parts of the lithographic apparatus, the friction e.g. causing thermal stress As another example, discharges may be caused by a gas flow in the lithographic apparatus which may result in electrostatic charge accumulation. The plasma discharges may result from plasma which excites gas particles in the lithographic apparatus. A location, a discharge energy and a time of occurrence of the discharge may be highly random or highly unpredictable. Moreover, the higher the radiation source intensity and the higher throughput and scanning velocities of the lithographic apparatus, the higher a risk of occurrence of such discharges may be and the higher a likelihood may be that the discharge may have an impact on the operation of the lithographic apparatus. In the lithographic apparatus, use may be made of a low pressure environment or a vacuum environment. In such low pressure or vacuum environment, the Although the above describes the occurrence of discharges in a lithographic apparatus, the same may take place in any exposure apparatus. The term exposure apparatus may be understood so as to comprise any exposure apparatus, such as a lithographic apparatus, an electron beam (e-beam) exposure apparatus, etc.

The inventors have realized that analysis of the discharges in the exposure apparatus may be obfuscated, on the one hand as the location and time of occurrence may be highly unpredictable, and on the other hand as the frequency content of the discharges may differ from discharge to discharge. A sensitivity of a detector may be too low, to adequately and accurately detect the discharges when occurring. Furthermore, in the exposure apparatus, a variety of signals may be emitted as a result of the operation of the exposure apparatus, e.g. emission by actuators, such as electrical motors, emission by electronic circuits, communication busses, power electronics, etc. By the presence of such signals, occurring electrostatic discharges may be obfuscated. Moreover, as the exposure apparatus may make use of compartments having metal walls, reflections of electromagnetic radiation may further obfuscate an analysis of the discharges, if detected by the detector at all.

An impact of a discharge in the exposure apparatus may strongly differ from discharge to discharge. On the one hand, a time of the discharge may or may not coincide with a time a critical or vulnerable process is performed by the exposure apparatus. Examples of critical or vulnerable processes in the exposure apparatus may include an exposure of a substrate, a calibration, a substrate positioning, etc. On the other hand, a location of the discharge and a discharge path may determine if a extent of the impact of the discharge on the operation of the exposure apparatus. Moreover, discharge energy may damage sensitive parts of the exposure apparatus.

Thus, the discharges may provide for disturbances at an unknowns moment in time, at an unknown place in the exposure apparatus, following an unknown electrical discharge path, exhibiting an unknown frequency content, and having an unknown impact on the exposure apparatus.

The present invention aims to enhance a reliability of operation of the exposure apparatus.

The inventor has devised that a monitoring of an operation of the exposure apparatus may be carried out. A detection system may be provided for use in the exposure apparatus. The detection system comprises at least two radio frequency receivers configured to receive signals in the exposure apparatus. The detection system further comprises a signal processing unit comprising a software defined radio configured to process the received signals. The signal processing unit is further configured to determine an occurrence of a discharge of charged particles in the exposure apparatus from the processed signals. The radio frequency receivers are configured to receive electromagnetic signals. The electromagnetic signals are processed by a software defined radio. The software defined radio may be understood as a radio system in which components that conventionally have been implemented in analog hardware, e.g. mixers, filters, amplifiers, modulators/demodulators, detectors, etc., are instead implemented by means of software on a computer or embedded system. The signal processing unit may for example comprise analogue to digital conversion to convert the received radio signal(s) into digital data. The term radio frequency receiver may be understood as a receiver configured to detect electromagnetic radiation. The radio frequency may be understood as a frequency band of the electromagnetic radiation suitable for radio communication, ranging from e.g. 3 kHz to 300 GHz.

Discharges may form a source of emission of electromagnetic radiation at radio frequencies. Time delay information from the at least two receivers detecting the radio waves may be used to determine the location of the discharge.

Each radio frequency receiver may comprise an antenna. The antennas may be arranged at a mutual distance from each other in the exposure apparatus. Accordingly, the at least two radio frequency receivers may receive partly the same signals, however with differences in phase, timing, amplitude, etc. as the signals are received at different locations in the exposure apparatus. As at least two radio frequency receivers are used, the processing unit may derive information regarding location from which a signal originates, etc. from the received signals.

**In** an exposure apparatus, a variety of sub systems may be active simultaneously, e.g. the substrate stage, the reticle stage (i.e. patterning device support), possibly the generation of radiation pulses, optics adjustments such as mirror adjustments, substrate loading robots and many others. As a result, a variety of such sub systems may emit electromagnetic radiation simultaneously due to activation of actuators (such as motors), high speed data communication, laser pulse generation, etc.

The software defined radio may enable to perform highly advanced detection and signal processing on the received electromagnetic signals. Accordingly, the software defined radio may be capable of distinguishing signals in the exposure apparatus where a variety of signals may be emitted simultaneously. The software defined radio may for example perform steep filtering operations and may perform correlation operations between the radio frequency signals received by the at least two radio frequency receivers.

In an embodiment, the signal processing unit is configured to synchronize the signals received from the at least two radio frequency receivers. The signals from the at least two radio frequency receivers may be synchronized by performing the analogue to digital conversion on the basis of a same sampling clock and by processing the data streams obtained by the analogue to digital converter on the basis of a same clock signal. By synchronizing the signals received from the at least two radio frequency receivers, the software defined radio may be configured to take account of synchronized patterns as may be received by the radio frequency receivers. For example, reflections or multiple reflections may take place at the metal walls of the exposure apparatus or parts thereof. As another example, the same signal may be received by plural of the radio frequency receivers. The synchronized detection by radio frequency receivers at different locations in the exposure apparatus may assist to determine a direction, an origin and/or a propagation path of the received radio frequency signals.

In an embodiment, the signal processing unit is configured to determine a position of the discharge from the signals received by the at least two radio frequency receivers. For example, the signal processing unit is configured to determine the position of the discharge from at least one of a phase of the processed signals, an amplitude of the processed signals and a time difference between the processed signals. The phase, amplitude and/or time difference of the processed signals at the at least two radio frequency receivers may assist to determine a difference in a propagation path length of the radio frequency signal from its origin to the respective antenna. As a further example, the signal processing unit is configured to determine the position of the discharge from a correlation between at least two of the phase of the processed signals, the amplitude of the processed signals and the time difference between the processed signals. The correlation between phase, amplitude and/or time difference may provide further information on propagation path characteristics from the origin of the radio frequency signal to the respective antennas. As another example, the signal processing unit is configured to determine a location of the discharge in the exposure apparatus using geometric data of the exposure apparatus. The geometric data of the exposure apparatus, e.g. geometric shapes of parts of the exposure apparatus, and/or geometric data on the locations of the antennas of the radio frequency receivers, may be taken into account. The information obtained regarding the propagation paths to the at least two antennas of the radio frequency receivers may be combined with the geometric data, to determine an origin of a particular signal component in the radio frequency signals received by the radio frequency receivers.

In an embodiment, the signal processing unit is configured to associate a time and/or a position of the discharge with momentary position data and/or state data of the exposure apparatus. The state of the exposure apparatus may change over time, e.g. during a cycle of loading a substrate, exposing, etc. Further, a position of parts of the lithographic apparatus may change over time, e.g. a position of a substrate table, a substrate table actuator and/or a position of a support that supports the patterning device. The different positions of such parts may affect a propagation path of the radio frequency signals from the origin thereof. Taking account of the momentary position data of the exposure apparatus may enable to more accurately determine a position of the origin of the radio frequency signal in the presence of a movable part. Taking account of the state of the exposure apparatus may enable to more accurately estimate a possible impact that the discharge may have on the operation of the lithographic apparatus. For example, during an alignment measurement process or during an exposure, an impact of a discharge may be larger than during a loading of a substrate.

In an embodiment, the processing unit is configured to determine a signal profile associated with a plasma discharge of a plasma based EUV generation system of the exposure apparatus, and to distinguish a detection of a discharge of charged particles from the plasma discharge of the plasma based EUV generation system. The exposure system may make use of a laser powered plasma based EUV generation system. The plasma discharge may generate radio frequency signals at a relatively high intensity, as high power EUV pulses may be generated. In order to distinguish the plasma discharge from other discharge effects in the exposure apparatus, the radio frequency signals may be compared with the signal profile associated with the plasma discharge, and if exhibiting a high similarity (e.g. a high correlation in terms of one of more of location, amplitude, duration, frequency content, etc.) the radio frequency signals in question may be assigned to originate from the plasma discharge.

In an embodiment, the antennas are configured to be arranged in a vacuum compartment of the exposure apparatus. For example, the software defined radio is configured to filter reflections in the vacuum compartment from the signal received from the radio frequency receivers. The vacuum compartment may comprise metal walls and may accordingly be highly reflective for radio frequency signals emitted therein. The high reflectivity may provide for a plurality of reflections of emitted radio frequency signals, which may obfuscate a retrieval of a position where the radio frequency signal originates from, i.e. a position where the radio frequency signal has been emitted. The software defined radio may facilitate a retrieval of characteristics of the propagation paths of the radio frequency signals form the plural radio frequency receivers.

In an embodiment, the signal processing unit is configured to determine a signal profile of the exposure apparatus during an operation of the exposure apparatus and to determine a deviation of the signal relative to the signal profile. The signal profile may express radio frequency signals as emitted by the exposure apparatus during an operation thereof. The signal profile may for example be determined from a monitoring of the radio frequency signals during one or plural operational cycles of the exposure apparatus, e.g. one or plural exposures of a substrate. Once the signal profile has been determined, the radio frequency signals as received may be compared to the signal profile, whereby deviations in the received radio frequency signal relative to the signal profile may be originate from disturbances, such as discharges. Accordingly, the discharges which may occur at an unknown time, location and with unknown frequency content, may be distinguished from regular, e.g. repetitive radio frequency emissions related to an expected operation of the exposure apparatus.

In an embodiment, the detection system comprises four radio frequency receivers, each comprising an antenna. Using 4 radio frequency receivers, a location of the origin of a received radio frequency signal may be accurately determined in a 3 dimensional space.

In an embodiment, the radio frequency receivers comprise fractal antenna's. As explained above, the fractal antennas may exhibit a high sensitivity over a wide bandwidth.

In an embodiment, the radio frequency receivers operate in a broadband frequency. For example, the radio frequency receivers may be configured to operate in a frequency band of 3 kHz to 300 GHz.

In an embodiment, the signal processing unit is further configured to determine an external disturbance outside the exposure apparatus from the processed signals. The exposure apparatus may be operated in a cleanroom environment of a semiconductor manufacturing facility. In the cleanroom environment of the semiconductor manufacturing facility, a variety of other devices may be operational, which may give rise to electromagnetic disturbances which may affect an operation of the exposure apparatus. The detection system arranged in the exposure apparatus may detect such electromagnetic disturbances. For example, the processing unit of the detection system may be configured to perform a logging of the detected radio frequency signals, thus to enable to perform a root cause analysis in the case of a disturbance or defect in the exposure apparatus, to detect internal causes such as discharges and/or external causes such as disturbances that originate from other devices in the cleanroom environment of the semiconductor manufacturing facility.

According to a further aspect, there is provided an exposure apparatus (such as a lithographic apparatus or an electron beam inspection apparatus) comprising the detection system.

In an embodiment of the exposure apparatus, the radio frequency receivers comprise antennas and wherein the antennas are arranged in a vacuum compartment of the exposure apparatus. In the vacuum compartment, due to the metal walls thereof, many reflections of emitted electromagnetic radiation may be detected by the radio frequency receivers. The software defined radio may be capable of analysing the received radio frequency signals in the presence of the multitude of reflections.

According to an aspect, there is provided a method of determining a cause of electrostatic discharge in an exposure apparatus, the method comprising: receiving by at least two radio frequency receivers signals in the exposure apparatus; processing the signals by a software defined radio, and determining an occurrence of a discharge of charged particles in the exposure apparatus from the processed signals. With the method of the invention, the same or similar effects may be achieved as with the detection system according to the invention. Also, the same or similar embodiments may be provided, providing the same or similar effects as described with reference to the detection system according to the invention.

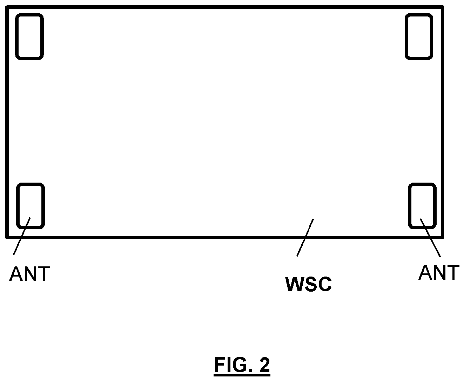

An example of the detection system will be described in the below with reference to Figures 2 - 5.

Figure 2 depicts a substrate stage compartment WSC of an exposure apparatus. The substrate stage WS of the exposure apparatus, such as the lithographic apparatus as depicted in and described with reference to Figure 1, may be arranged in the substrate stage compartment. The radio frequency receivers of the detection system may each comprise an antenna configured to receive a radio frequency signal, such as electromagnetic signal. As depicted in Figure 2, antennas ANT are arranged in the substrate stage compartment WSC. For example, in an embodiment, 4 antennas ANT are arranged in the substrate stage compartment WSC. The substate stage compartment may be rectangular in shape, wherein the antennas are each arranged in a corner of the substrate stage compartment.

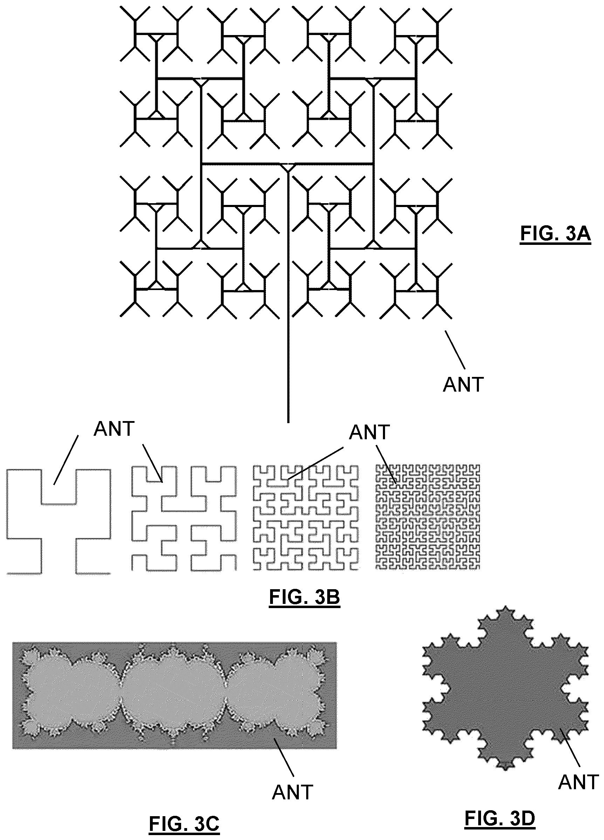

In an embodiment, the antennas may each comprise a fractal antenna. A fractal antenna may be understood as an antenna that uses a fractal, self-similar design to maximize an effective length thereof, or increase a perimeter (on inside sections or the outer structure), of material that can receive or transmit electromagnetic radiation within a given total surface area or volume. Such fractal antennas are also referred to as multilevel and space filling curves. A key aspect may lie in their repetition of a motif over two or more scale sizes, or "iterations". For this reason, fractal antennas may be very compact, multiband or wideband. A fractal antenna's response may differ markedly from traditional antenna designs, in that it may be capable of operating with good-to-excellent performance at many different frequencies simultaneously. Figure 3A - 3D depict examples of fractal antennas. Figure 3A depicts an example of a fractal antenna design comprising a layered pattern of H shaped microstrip transmission lines. Figure 3B depicts examples of a Hilbert curve based monopole antenna pattern. Figure 3C depicts an example of a Mandelbrot based microstrip patch antenna. Figure 3D depicts an example of a Koch patch antenna.

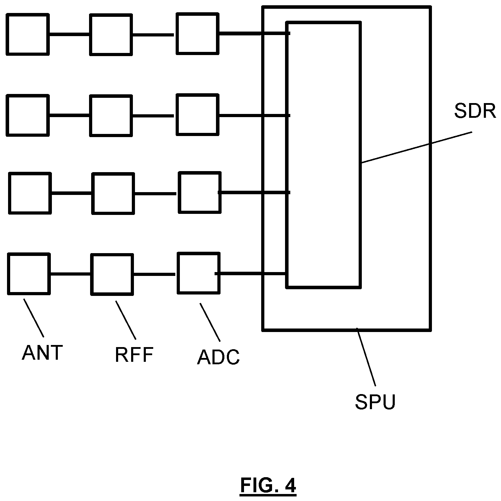

Figure 4 depicts a block schematic view of the detection system. The detection system comprises a plurality of radio frequency receivers RFR to receive radio frequency signals, each radio frequency receiver comprising an antenna ANT and a radio frequency front end RFF. The radio frequency front end may for example comprise mixer, tuner, band filter or any combination thereof. Further, the radio frequency front end may comprise a wideband pre-amplifier to amplify the radio frequency signals received by the antennas. The detection system further comprises a signal processing unit SPU to process the radio frequency signals received by the receiver. The signal processing unit comprises analogue to digital converters ADC, e.g. an analogue to digital converter per radio frequency receiver, and a software defined radio SDR which is configured to receive and process data streams from the analogue to digital converters. The RF-frontend may enable to perform downmixing, tuning, and/or direct conversion of the received radio frequency signals. The mixer of the radio frequency front end may enable the synchronized downmixing of the received radio frequency signal, and may therefore enhance capabilities of the ADC's, as the ADC's may accordingly sample more in a given timeframe.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A detection system for use in an exposure apparatus, comprising:
at least two radio frequency receivers configured to receive signals in the exposure apparatus;
a signal processing unit comprising a software defined radio configured to process the received signals, wherein the signal processing unit is further configured to determine an occurrence of a discharge of charged particles in the exposure apparatus from the processed signals.

2. The detection system according to any one of the preceding claims, wherein the signal processing unit is configured to synchronize the signals received from the at least two radio frequency receivers.

3. The detection system according to any one of the preceding claims, wherein the signal processing unit is configured to determine a position of the discharge from the signals received by the at least two radio frequency receivers.

4. The detection system according to claim 3, wherein the signal processing unit is configured to determine the position of the discharge from at least one of a phase of the processed signals, an amplitude of the processed signals and a time difference between the processed signals.

5. The detection system according to claim 4, wherein the signal processing unit is configured to determine the position of the discharge from a correlation between at least two of the phase of the processed signals, the amplitude of the processed signals and the time difference between the processed signals.

6. The detection system according to any one of claims 3 - 5, wherein the signal processing unit is configured to determine a location of the discharge in the exposure apparatus using geometric data of the exposure apparatus.

7. The detection system according to any one of the preceding claims, wherein the signal processing unit is configured to associate a time and/or a position of the discharge with momentary position data and/or state data of the exposure apparatus.

8. The detection system according to any one of the preceding claims, wherein the processing unit is configured to determine a signal profile associated with a plasma discharge of a plasma based EUV generation system of the exposure apparatus, and to distinguish a detection of a discharge of charged particles from the plasma discharge of the plasma based EUV generation system.

9. The detection system according to any one of the preceding claims, wherein the antennas are configured to be arranged in a vacuum compartment of the exposure apparatus.

10. The detection system according to claim 9, wherein the software defined radio is configured to filter reflections in the vacuum compartment from the signal received from the radio frequency receivers.

11. The detection system according to any one of the preceding claims, wherein the signal processing unit is configured to determine a signal profile of the exposure apparatus during an operation of the exposure apparatus and to determine a deviation of the signal relative to the signal profile.

12. The detection system according to any one of the preceding claims, comprising four radio frequency receivers, each comprising an antenna.

13. The detection system according to any one of the preceding claims, wherein the radio frequency receivers comprise fractal antenna's.

14. The detection system according to any one of the preceding claims, wherein the radio frequency receivers operate in a broadband frequency.

15. The detection system according to any one of the preceding claims, wherein the signal processing unit is further configured to determine an external disturbance outside the exposure apparatus from the processed signals.

16. An exposure apparatus comprising the detection system according to any one of the preceding claims.

17. The exposure apparatus according to claim 16, wherein the radio frequency receivers comprise antennas and wherein the antennas are arranged in a vacuum compartment of the exposure apparatus.

18. A method of determining a cause of electrostatic discharge in an exposure apparatus, the method comprising:
receiving by at least two radio frequency receivers signals in the exposure apparatus;
processing the signals by a software defined radio, and
determining an occurrence of a discharge of charged particles in the exposure apparatus from the processed signals.
